# EUROPÄISCHE PATENTANMELDUNG

(11) **EP 2 028 581 A2**
(43) Veröffentlichungstag der Anmeldung: **25.02.2009**
(21) Anmeldenummer: 08101902.8
(22) Anmeldetag: 22.02.2008
(51) Int. Cl.: G06F 1/18

(54) **Computer und Verfahren zur Befestigung einer Leiterplatte an einem Trägerblech**

(30) Priorität: 24.08.2007 DE 102007040085
(71) Anmelder: Fujitsu Siemens Computers GmbH, 80807 München (DE)
(72) Erfinder: Köhler, Freidrich, 86405 Meitingen (DE); Schelshorn, Lorenz, 86179 Augsburg (DE)
(74) Vertreter: Rietzler, Alwin

(57) **Zusammenfassung**

Die Erfindung betrifft einen Computer mit einem Trägerblech, welches zur Befestigung einer Leiterplatte eingerichtet ist und an welchem ein Stehbolzen mit einem Bolzenkopf und einem Bolzenfuß angeordnet ist und einer Leiterplatte, welche eine Öffnung aufweist, die dazu dient, mit dem Stehbolzen zusammenzuwirken und deren Abmessungen so gewählt sind, dass der Bolzenkopf durch die Öffnung hindurchführbar ist und dass bei einem Verschieben der Leiterplatte relativ zum Stehbolzen die Leiterplatte den Bolzenkopf teilweise untergreift. Dabei ist an der Leiterplatte oder am Trägerblech eine hervorstehende Fläche angeordnet, welche dazu eingerichtet ist, mit einem elastischen Element zusammenzuwirken, das, am jeweilig anderen Bauteil als die hervorstehende Fläche, am Trägerblech oder an der Leiterplatte angeordnet ist.

Die Erfindung betrifft des weiteren ein Verfahren zur Befestigung einer Leiterplatte an einem Trägerblech in einem derartigen Computer, wobei im ersten Schritt die Leiterplatte in das Trägerblech eingesetzt und soweit verschoben wird, bis die Leiterplatte den Bolzenkopf teilweise untergreift, wobei das elastische Element so angeordnet ist, dass es in dieser Stellung noch nicht elastisch verformt wird, und im zweiten Schritt die Leiterplatte gegen den Stehbolzen soweit verschoben wird, dass das elastische Element mit der hervorstehenden Fläche in Kontakt gerät und durch sie elastisch verformt wird.

## Beschreibung

Die Erfindung betrifft einen Computer mit einem Trägerblech, welches zur Befestigung einer Leiterplatte eingerichtet ist und an welchem ein Stehbolzen mit einem Bolzenkopf und einem Bolzenfuß angeordnet ist und einer Leiterplatte, welche eine Öffnung aufweist, die dazu dient, mit dem Stehbolzen zusammenzuwirken und deren Abmessungen so gewählt sind, dass der Bolzenkopf durch die Öffnung hindurchführbar ist und dass bei einem Verschieben der Leiterplatte relativ zum Stehbolzen die Leiterplatte den Bolzenkopf teilweise untergreift.

Die Erfindung betrifft weiterhin ein Verfahren zur Befestigung einer Leiterplatte an einem Trägerblech gemäß dem Oberbegriff des Anspruches 7.

Die DE 102005061827 A1 offenbart einen derartigen Computer sowie ein Verfahren nach dem Oberbegriff des Anspruches 7. Ein elastisches Element, das den Bolzenfuß zumindest teilweise umgreift, dient dazu, die Leiterplatte gegen den Bolzenkopf zu drücken.
Durch das elastische Element soll eine zuverlässige Kontaktierung zwischen Bolzenkopf und Leiterplatte erzielt werden.

Ein Nachteil dieses Aufbaus ist, dass beim Einlegen der Leiterplatte das elastische Element verformt wird, was zur Folge hat, dass bei dem Einlegen der Leiterplatte Kraft aufgewendet werden muss.

Das elastische Element in der DE 102005061827 A1 ist als Kontaktfeder ausgebildet, welche in einem Winkel auf die Leiterplatte stößt. Wird der Bolzenkopf bei bestehendem Kontakt von Leiterplatte und Kontaktfeder durch ein Kreisloch in der Leiterplatte geführt, so weicht die Kontaktfeder dem Druck senkrecht zur Bewegungsrichtung aus und reibt an der Leiterplatte. In einem zweiten Schritt muss die Leiterplatte versetzt werden, damit die Leiterplatte den Bolzenkopf untergreift. Bei diesem Versatz der Leiterplatte entsteht weiterer Reibungswiderstand.

Der Erfindung liegt daher die Aufgabe zugrunde, eine Lösung aufzuzeigen, welche eine leichtere Montage der Leiterplatte an das Trägerblech ermöglicht.

Diese Aufgabe wird erfindungsgemäß dadurch gelöst, dass an der Leiterplatte, oder am Trägerblech eine hervorstehende Fläche angeordnet ist, welche dazu eingerichtet ist, mit einem elastischen Element zusammen zu wirken, welches, am jeweils anderen Bauteil als die hervorstehende Fläche, am Trägerblech oder an der Leiterplatte angeordnet ist.

Die Aufgabe wird ebenso gelöst durch ein Verfahren zur Befestigung der Leiterplatte an dem Trägerblech, wobei in einem ersten Schritt die Leiterplatte in das Trägerblech eingesetzt und soweit verschoben wird, bis sie den Bolzenkopf teilweise untergreift, wobei das elastische Element so angeordnet ist, dass es in dieser Stellung noch nicht elastisch verformt wird und in einem zweiten Schritt die Leiterplatte gegen den Stehbolzen so weit verschoben wird, dass das elastische Element mit der hervorstehenden Fläche in Kontakt gerät und durch sie elastisch verformt wird.

Der Vorteil der Lösung ist, dass bei dem Einsetzen der Leiterplatte in das Trägerblech keine Reibungskraft entsteht.

Erst ab der Stellung, in welcher die hervorstehende Fläche mit dem elastischen Element in Kontakt tritt, entsteht Reibung. Die Größe der Reibungskraft und somit des Reibungswiderstands wird durch die Dicke der hervorstehenden Fläche, durch die Federkonstante des elastischen Elements, sowie durch das Material bestimmt.

In einer vorteilhaften Weiterbildung der Erfindung ist das elastische Element elektrisch leitfähig ausgebildet und die hervorstehende Fläche als Massekontaktfläche ausgebildet, so dass durch den Kontakt von dem elastischen Element und der Massekontaktfläche eine elektrisch leitfähige Verbindung zwischen Leiterplatte und Trägerblech hergestellt wird.

Der Vorteil der vorgenannten Maßnahme zeigt sich darin, dass die elektrische Kontaktierung von Leiterplatte nicht über den Stehbolzen erfolgen muss. Der Stehbolzen wird zur Befestigung der Leiterplatte an das Trägerblech verwendet. Seine Form und seine Materialeigenschaften bestimmen die Festigkeit der Befestigung. Die Kontaktierung der Leiterplatte geschieht unabhängig davon durch das elastische Element, welches somit maßgeblich die Qualität der elektrischen Kontaktierung bestimmt. Die Unabhängigkeit von Kontaktierung und Fixierung vergrößert die Toleranz in der Dicke der Leiterplatte und erhöht die Zuverlässigkeit der Herstellung des elektrischen Kontakts bei der Montage.

Für die vorstehend beschriebene Erfindung ist die Art der Leiterplatte von untergeordneter Bedeutung. So kann die Leiterplatte eine Grafikkarte, ein Controller, ein Computermainboard oder eine andere Komponente eines Computers sein.

Das Trägerblech, welches zur Befestigung der Leiterplatte dient, kann sowohl auf dem Computergehäuse angeordnet sein, als auch als Gehäusewandung des Computers ausgebildet sein. Der Vorteil letztgenannter Ausführung liegt in der Einsparung von Material.

Nachfolgend wird anhand in den Figuren dargestellter Ausführungsbeispiele die Erfindung näher erläutert.

Es zeigt:
- Figur 1: eine Leiterplatte mit hervorstehender Massekontaktfläche und ein Computergehäuse mit Trägerblech, an welchem ein elastisches Element und ein Stehbolzen angeordnet sind,
- Figur 2: die Anordnung gemäß Figur 1 mit gespanntem elastischen Element,
- Figur 3: ein Computergehäuse mit Trägerblech, an welchem eine hervorstehende Massekontaktfläche und ein Stehbolzen angeordnet sind und eine Leiterplatte, an welcher ein elastisches Element angeordnet ist,
- Figur 4: die Anordnung gemäß Figur 3 mit gespanntem elastischen Element,
- Figur 5: eine Leiterplatte in teilweiser Schrägansicht mit hervorstehenden Massekontaktflächen und ein Trägerblech mit elastischen Elementen und Stehbolzen,
- Figur 6: einen Stehbolzen mit einem Bolzenkopf, einem Bolzenfuß und einem Anschlag, welcher an einem Trägerblech angeordnet ist und eine Leiterplatte mit einer Öffnung aus einem Kreisloch und einem Langloch vor der Montage und
- Figur 7: die Anordnung gemäß Figur 6 nach der Montage.

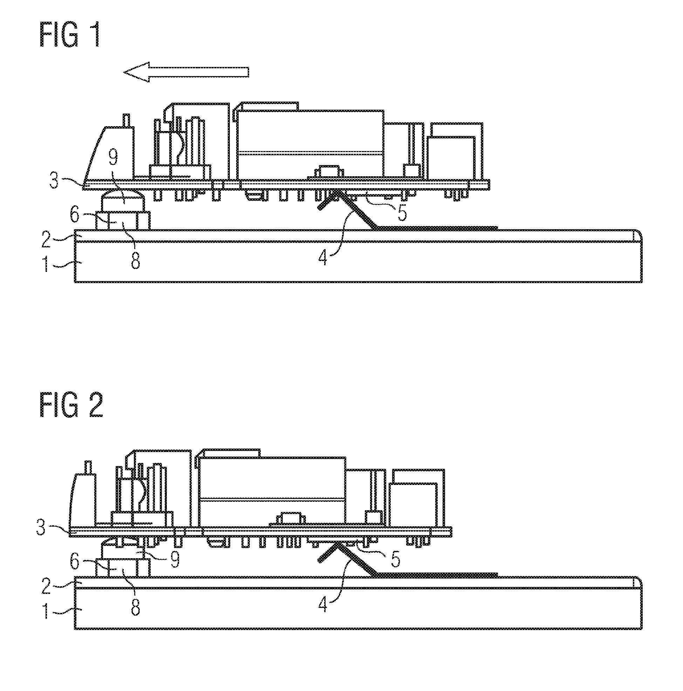

Figur 1 zeigt in einer teilweise schematisierten Seitendarstellung ein Computergehäuse 1 mit einem Trägerblech 2, auf welchem ein Stehbolzen 6 mit einem Anschlag 9 und beabstandet hierzu ein elastisches Element 4 angeordnet sind. Weiterhin ist eine Leiterplatte 3 ebenfalls seitlich, schematisiert dargestellt, an welcher eine hervorstehende Fläche 5 ausgebildet ist. In der Darstellung liegt die Leiterplatte 3 auf dem Anschlag 9 des Stehbolzens 6 auf. Die hervorstehende Fläche 5 ist gegenüber dem elastischen Element 4 angeordnet. Das elastische Element 4 ist in dieser Stellung nicht elastisch verformt und eine Berührung mit der hervorstehenden Fläche 5 findet nicht statt.

Im dargestellten Ausführungsbeispiel ist das elastische Element 4 als metallische Kontaktfeder ausgebildet, welche aus dem Trägerblech 2 herausgestanzt ist. Alternativ hierzu kann die Kontaktfeder an das Trägerblech 2 geschweißt sein. Die hervorstehende Fläche 5 ist bevorzugt als Massekontaktfläche ausgebildet.

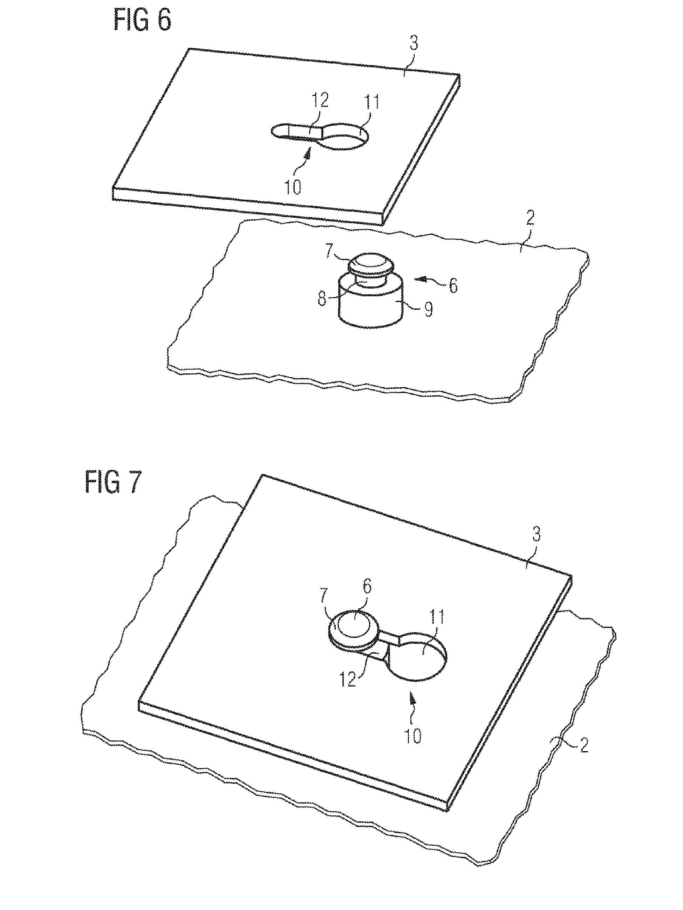

Die Figur 2 zeigt die Anordnung gemäß Figur 1 in montierter Stellung. Die Leiterplatte 3 wurde zur Montage seitlich relativ zum Trägerblech 2 verschoben. Das Verfahren der Befestigung der Leiterplatte 3 am Trägerblech 2 ist in den Figuren 6 und 7 näher erläutert. In Figur 2 berührt das elastische Element 4 die hervorstehende Fläche 5 und wird durch sie verformt. In dieser Stellung wird eine elektrisch leitfähige Kontaktierung von Leiterplatte 3 und Trägerblech 2 erzielt.

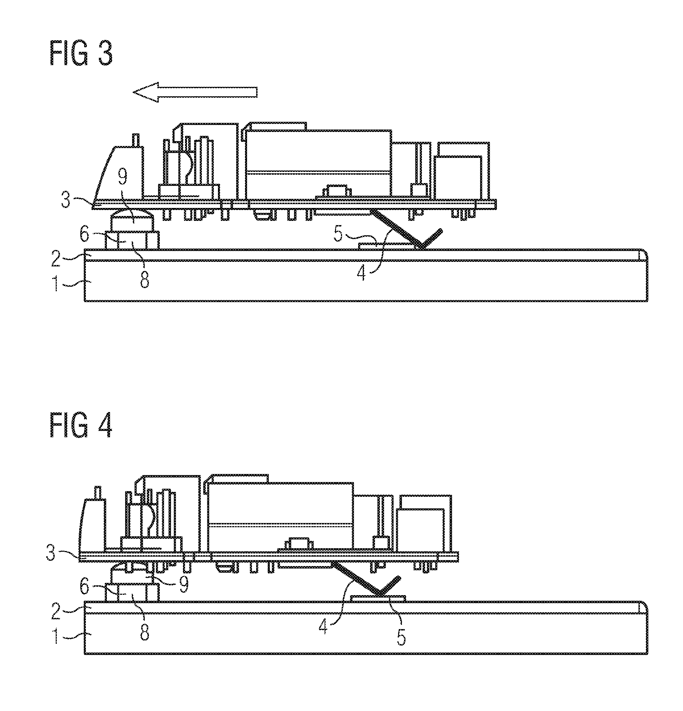

Die Figuren 3 und 4 stellen die Erfindung in einer alternativen Ausgestaltung dar. Das elastische Element 4 ist an der Leiterplatte 3 angeordnet, wohingegen die Fläche 5 aus dem Trägerblech 2 hervorsteht.

Die Figur 4 unterscheidet sich wiederum von der Figur 3 durch die gegenseitige Lage von Trägerblech 2 und Leiterplatte 3; eine Verschiebung bewirkt eine elastische Verformung des an der Leiterplatte 3 angeordneten elastischen Elements 4 sowie die damit zusammenhängende Kontaktierung von Trägerblech 2 und Leiterplatte 3.

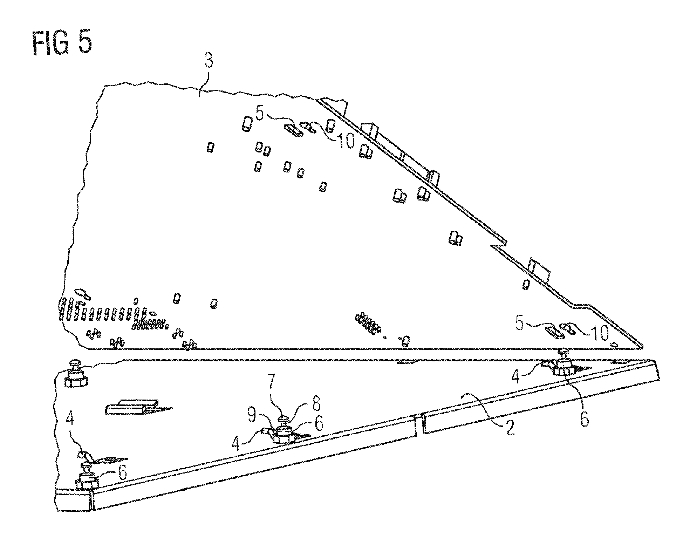

In Figur 5 ist eine Ausgestaltung der Erfindung in dreidimensionaler Darstellung zu sehen, bei welcher die Stehbolzen 6 optimiert zu den elastischen Elementen 4 angeordnet sind. Der dargestellte Ausschnitt zeigt die zum Trägerblech 2 gerichtete Seite der Leiterplatte 3 sowie die Oberseite des Trägerblechs 2. Auf dem Trägerblech 2 sind im dargestellten Ausschnitt vier Stehbolzen 6 sowie drei elastische Elemente 4 in Form von Kontaktfedern angeordnet, und auf der Leiterplatte 3 sind weiterhin zwei hervorstehende Flächen 5 angeordnet.

Es ist von Vorteil, wenn die elastischen Elemente 4 und die hervorstehenden Flächen 5 in unmittelbarer Nachbarschaft der Stehbolzen 6 angeordnet sind. Dies sichert eine zuverlässige elektrische Kontaktierung für den Fall, dass die Leiterplatte 3 nicht ebenmäßig gefertigt ist bzw. sich mit der Zeit verwindet oder verbiegt. Es ist weiterhin von Vorteil, die an der Leiterplatte 3 angeordneten hervorstehenden Flächen 5 relativ zum elastischen Element 4 mit genügend breiter Ausdehnung auszubilden, um seitlich eine Toleranz in der Lage von Leiterplatte 3 zum Trägerblech 2 zu gewinnen.

Anhand der Figuren 6 und 7 wird nachfolgend die Befestigung der Leiterplatte 3 mittels der Stehbolzen 6 am Trägerblech 2 erläutert.

Der in Figur 6 an einem schematischen Ausschnitt des Trägerblechs 2 angeordnete Stehbolzen 6 besteht aus einem Bolzenkopf 7 und einem Bolzenfuß 8. An dem Bolzenfuß 8 ist der Anschlag 9 ausgebildet, auf welchen die Leiterplatte 3 beim Einsetzen abgelegt werden kann. Der Bolzenfuß 8 und der Anschlag 9 sind bevorzugt zylinderförmig ausgebildet und der Bolzenkopf 7 ist üblicherweise pilzförmig ausgebildet. Alternativ hierzu kann der Bolzenkopf 7 als eine Abwinkelung des Bolzenfußes 8 hakenförmig ausgebildet sein. Es ist vorteilhaft, einen pilzförmigen Bolzenkopf 7 an seiner zum Trägerblech 2 hin gerichteten Seite mit einer Einführschräge zu versehen, um das Einführen der Leiterplatte 3 beim Montageprozess zu erleichtern.

Das Material des Stehbolzens 6 kann elektrisch leitfähig oder elektrisch nicht leitfähig ausgebildet sein. Der Vorteil eines elektrisch leitfähigen Stehbolzens 6 ist die Möglichkeit der Kontaktierung von Leiterplatte 3 und Trägerblech 2 mit dessen Hilfe. Der Vorteil eines Stehbolzens 6, welcher aus einem Kunststoff gefertigt ist, besteht in der Möglichkeit, ihn an das Trägerblech 2 kostengünstig zu kleben, was zudem keine sichtbaren Spuren an der Außenseite des Trägerblechs 2 hinterlässt. Hierdurch wird ermöglicht, das Trägerblech 2 kostengünstig direkt als Wandung des Computersgehäuses 1 auszubilden.

Die Leiterplatte 3 weist in dem dargestellten Ausführungsbeispiel eine schlüssellochförmige Öffnung 10 aus einem Kreisloch 11 mit einem sich anschließenden Langloch 12 auf. Das Kreisloch 11 ist mit einem geringfügig größeren Durchmesser als der des Bolzenkopfes 7 ausgebildet. Das Langloch 12 weist einen Durchmesser auf, der geringfügig größer als der Durchmesser des Bolzenfußes 8 ist.

Figur 6 zeigt die Leiterplatte 3 und das Trägerblech 2 vor der Montage. In einem ersten Schritt wird der Bolzenkopf 7 durch das Kreisloch 11 geführt und die Leiterplatte 3 auf den Anschlag 9 gelegt. Nach dem Auflegen der Leiterplatte 3 auf den Anschlag 9 wird diese entlang des Langlochs 12 unter dem Bolzenkopf 7 verschoben, wobei der Bolzenfuß 8 in dem Langloch 12 bewegt wird. Das elastische Element 4 wird dabei bisher nicht elastisch verformt. In einem Moment der Bewegung wirkt die Leiterplatte 3 mit dem Stehbolzen 6 so zusammen, dass sie fest gehalten wird. Die hervorstehende Fläche 5 ist so angeordnet, dass sie nun mit dem elastischen Element 4 in Kontakt gerät. Die Bewegung wird fortgesetzt und die Kraft, welche zur Verformung des elastischen Elements 4 aufgewendet wird, wir durch den Bolzenkopf 7 abgefangen, sie wirkt als Reibungswiderstand der Bewegung entgegen.

Die Figur 7 zeigt das Ende der Montage, die Leiterplatte 3 hat ihre Endposition erreicht. In dieser Stellung untergreift die Leiterplatte 3 den Bolzenkopf 7 und das elastische Element 4 kontaktiert die hervorstehende Fläche 5.

### Bezugszeichenliste

- 1: Computergehäuse
- 2: Trägerblech
- 3: Leiterplatte
- 4: Elastisches Element
- 5: Hervorstehende Fläche
- 6: Stehbolzen
- 7: Bolzenkopf
- 8: Bolzenfuß
- 9: Anschlag
- 10: Öffnung
- 11: Kreisloch
- 12: Langloch

## Patentansprüche

1. Computer mit einem Trägerblech (2), welches zur Befestigung einer Leiterplatte eingerichtet ist und an welchem ein Stehbolzen (6) mit einem Bolzenkopf (7) und einem Bolzenfuß (8) angeordnet ist und einer Leiterplatte (3), welche eine Öffnung (10) aufweist, die dazu dient, mit dem Stehbolzen (6) zusammenzuwirken und deren Abmessungen so gewählt sind, dass der Bolzenkopf (7) durch die Öffnung (10) hindurchführbar ist und dass bei einem Verschieben der Leiterplatte (3) relativ zum Stehbolzen (6) die Leiterplatte (3) den Bolzenkopf (7) teilweise untergreift,
**dadurch gekennzeichnet, dass**
an der Leiterplatte (3) oder am Trägerblech (2) eine hervorstehende Fläche (5) angeordnet ist, welche dazu eingerichtet ist, mit einem elastischen Element (4) zusammenzuwirken, welches, am jeweilig anderen Bauteil als die hervorstehende Fläche (5), am Trägerblech (2) oder an der Leiterplatte (3) angeordnet ist.

2. Computer nach Anspruch 1,
**dadurch gekennzeichnet, dass**
das elastische Element (4) elektrisch leitfähig ausgebildet ist und die hervorstehende Fläche (5) als Massekontaktfläche ausgebildet ist, so dass durch den Kontakt von dem elastischen Element (4) und der Massekontaktfläche (5) eine elektrisch leitfähige Verbindung zwischen Leiterplatte (3) und Trägerblech (2) hergestellt wird.

3. Computer nach Anspruch 1 oder Anspruch 2,
**dadurch gekennzeichnet, dass**
das Trägerblech (2) die Gehäusewandung eines Computergehäuses (1) ist.

4. Computer nach einem der vorherigen Ansprüche,
**dadurch gekennzeichnet, dass**
die Leiterplatte (3) ein Motherboard ist.

5. Computer nach einem der vorherigen Ansprüche,
**dadurch gekennzeichnet, dass**
das elastische Element (4) eine Kontaktfeder ist.

6. Computer nach einem der vorherigen Ansprüche,
**dadurch gekennzeichnet, dass**
die Öffnung (10) der Leiterplatte (3) ein Kreisloch (11) mit einem sich anschließenden Langloch (12) ist.

7. Verfahren zur Befestigung einer Leiterplatte (3) an einem Trägerblech (2), wobei an dem Trägerblech (2) ein Stehbolzen (6) mit einem Bolzenkopf (7) und einem Bolzenfuß (8) angeordnet ist und die Leiterplatte (3) eine Öffnung (10) aufweist, welche dazu dient mit dem Stehbolzen (6) zusammenzuwirken und deren Abmessungen so gewählt sind, dass der Bolzenkopf (7) durch die Öffnung (10) hindurchführbar ist und dass bei einem Verschieben der Leiterplatte (3) relativ zum Stehbolzen (6) die Leiterplatte (3) den Bolzenkopf (7) teilweise untergreift,
**dadurch gekennzeichnet, dass**
an der Leiterplatte (3) oder am Trägerblech (2) eine hervorstehende Fläche (5) angeordnet ist, welche dazu eingerichtet ist mit einem elastischen Element (4) zusammenzuwirken, das, am jeweilig anderen Bauteil als die hervorstehende Fläche (5), am Trägerblech (2) oder an der Leiterplatte (3) angeordnet ist, wobei im ersten Schritt die Leiterplatte (3) in das Trägerblech (2) eingesetzt und soweit verschoben wird, bis die Leiterplatte (3) den Bolzenkopf (7) teilweise untergreift, wobei das elastische Element (4) so angeordnet ist, dass es in dieser Stellung noch nicht elastisch verformt wird, und im zweiten Schritt die Leiterplatte (3) gegen den Stehbolzen (6) soweit verschoben wird, dass das elastische Element (4) mit der hervorstehenden Fläche (5) in Kontakt gerät und durch sie elastisch verformt wird.

8. Verfahren nach Anspruch 7,
**dadurch gekennzeichnet, dass**
das elastische Element (4) elektrisch leitfähig ausgebildet ist und die hervorstehende Fläche (5) als Massekontaktfläche ausgebildet ist, so dass durch den Kontakt von dem elastischen Element (4) und der Massekontaktfläche (5) eine elektrisch leitfähige Verbindung zwischen Leiterplatte (3) und Trägerblech (2) hergestellt wird.

9. Verfahren nach Anspruch 7 oder Anspruch 8,
**dadurch gekennzeichnet, dass**
das Trägerblech (2) die Gehäusewandung eines Computergehäuses (1) ist.

10. Verfahren nach einem der vorherigen Ansprüche 7 bis 9,
**dadurch gekennzeichnet, dass**
die Leiterplatte (3) ein Motherboard ist.

11. Verfahren nach einem der vorherigen Ansprüche 7 bis 10,
**dadurch gekennzeichnet, dass**
das elastische Element (4) eine Kontaktfeder ist.

12. Verfahren nach einem der vorherigen Ansprüche 7 bis 11,
**dadurch gekennzeichnet, dass**
die Öffnung (10) der Leiterplatte (3) ein Kreisloch (11) mit einem sich anschließenden Langloch (12) ist.
